# EUROPÄISCHE PATENTSCHRIFT

(11) **EP 1 277 221 B1**
(45) Veröffentlichungstag und Bekanntmachung des Hinweises auf die Patenterteilung: **26.05.2004**
(21) Anmeldenummer: 01919129.5
(22) Anmeldetag: 31.01.2001
(51) Int. Cl.: H01J 37/05

(54) **STRAHLERZEUGUNGSSYSTEM FÜR ELEKTRONEN ODER IONENSTRAHLEN HOHER MONOCHROMASIE ODER HOHER STROMDICHTE**
ELECTRON/ION GUN FOR ELECTRON OR ION BEAMS WITH HIGH MONOCHROMASY OR HIGH CURRENT DENSITY
CANON ELECTRONIQUE POUR ELECTRONS OU FAISCEAUX IONIQUES DE HAUTE MONOCHROMIE OU DE HAUTE DENSITE DE COURANT

(30) Priorität: 26.04.2000 DE 10020382
(43) Veröffentlichungstag der Anmeldung: 22.01.2003
(73) Patentinhaber: Ceos Corrected Electron Optical Systems GmbH, 69126 Heidelberg (DE)
(72) Erfinder: UHLEMANN, Stephan, 69115 Heidelberg (DE); HAIDER, Maximilian, 69251 Gaiberg (DE)
(74) Vertreter: Pöhner, Wilfried Anton, Dr.
(86) Internationale Anmeldenummer: PCT/DE2001/000409
(87) Internationale Veröffentlichungsnummer: WO 2001/082330

(56) Entgegenhaltungen:
- EP-A- 0 883 157
- DE-A- 19 633 496
- US-A- 2 429 558
- US-A- 4 812 652
- US-A- 5 359 197
- PATENT ABSTRACTS OF JAPAN vol. 1999, no. 12, 29. Oktober 1999 (1999-10-29) & JP 11 191384 A (JEOL LTD), 13. Juli 1999 (1999-07-13) & US 6 140 645 A ((TSUNO KATSUSHIGE) 31. Oktober 2000 (2000-10-31)

## Beschreibung

Die Erfindung bezieht sich auf ein Strahlerzeugungssystem für Elektronen oder Ionenstrahlen mit einer Strahlquelle und einen Monochromator mit Ablenkfeldern, welche in der dispersiven Ebene ein astigmatisches Zwischenbild der Strahl quelle erzeugen, und einer Schlitzblende in der dispersiven Ebene mit einer Orientierung des Schlitzes in Richtung der Längsausdehnung des astigmatischen Zwischenbildes, wobei der Nonochromator mit einem zusätzlichen Strahlführungssystem ausgestattet ist und an seinem Eingang ein Umschaltelement aufweist, das die von der Strahlquelle kommenden Teilchen entweder in den Monochromator oder dem zusätzlichen Strahlführungssystem zuführt.

Zur Untersuchung mikroskopischer Strukturen werden häufig Elektronen- oder Ionenstrahlen eingesetzt. Dabei wird unter Hochvakuum der aus einem Strahlerzeugungssystem austretende Teilchenstrahl mit Hilfe elektronen- oder ionenoptischer Abbildungssysteme auf die zu untersuchenden Strukturen gelenkt. Die Teilchen des Teilchenstroms erfahren hierbei infolge der Wechselwirkung mit der zu untersuchenden Materie eine Änderung ihrer Eigenschaften, die mit Hilfe von Detektoreinrichtungen registriert und anhand dieser Änderungen Aussagen über den Aufbau der Strukturen gewonnen werden. Bekannte Verfahren, welche auf diesem Prinzip beruhen, sind beispielsweise Röntgenanalyse, Energieverlustspektroskopie, Transmissionselektronenmikroskopie oder Rasterelektronenmikroskopie. Ebenfalls zu diesem Verfahren gehört die Elementanalyse, bei der hinter jedem Punkt des Objektes das Energiespektrum ermittelt wird und aus der Lage des Punktes und dem Energiespektrum zusammen Aussagen über das Objekt gewonnen werden.

Bei diesen Verfahren sind entscheidende Parameter der abbildenden Teilchen die Teilchenstromdichte und die Monochromasie der Teilchen. In der Elektronemmilcroskopie z. B. werden zur Vermeidung des chromatischen Bildfehlers, der die Auflösung des Systems begrenzt, Elektronen mit einer sehr geringen Energiebreite, d. h. möglichst hoher Monochromasie, benötigt. Die Energieverlustspektroskopie beispielsweise ist dagegen auf hohe Teilchenstromdichten angewiesen, um eine ausreichende Ausbeute an gestreuten Teilchen zu erhalten und damit die Analyse in endlicher Zeit durchführen zu Können.

Die bekannten Systeme zur Erzeugung von Teilchenströmen sind so aufgebaut, daß sie entweder hohe Teilchendichten oder hohe Monochromasie (DE 196 33 496 Al) erzeugen. will man Analysen durchführen, die alternativ sowohl hohe Teilchendiehten als auch hohe Monochromasie erfordern, ist man daher auf den Einsatz von zwei verschiedenen Strahlerzeugungssystemen angewiesen, die nach dem heutigen Stand der Technik in getrennten Apparaturen zur Verfügung gestellt werden.

Aus den Patent Abstracts of Japan vol. 1999, no. 12, 29. Oktober 1999 (JP 11 191384 A) ist bereits ein Monochromator bekannt, der mit magnetischen Ablenkfeldern arbeitet und der hinter dem Streuobjekt zur energetischen Analyse der Streuelektronen angeordnet ist. Die Erzeugung eines Abbildungsstrahles unterschiedlicher Eigenschaften (hohe Monochromasie oder hohe Teilchenstrahldichte) ist diesem Dokument fremd.

Die Erfindung hat sich zur Aufgabe gestellt, diesem Nachteil Abhilfe zu verschaffen und den Bedarf nach einem Strahlerzeugungssystem für Elektronen oder Ionen zu entsprechen, das wahlweise einen Teilchenstrom mit hoher Monochromasie bei niedriger Teilchenstromdichte oder einen Strom hoher Teilchenstromdichte bei geringer Monochromasie zur Verfügung stellt.

Ausgehend von einem Strahlerzeugungssystem mit Strahlquelle und Monochromator wird diese Aufgabe (gemäß dem Anspruch 1) dadurch gelöst, daß der Monochromator ausschließlich elektrostatische Ablenkfelder aufweist und eine Strahlquelle vorhanden ist, welche durch die Ablenkfelder in das astigmatische Zwischenbild abgebildet ist, wobei der monochromator mit einem zusätzlichen Strahlführungssystem ausgestattet ist.

In Abhängigkeit des vom Umschaltelement vorgegeben Teilchenweges werden Teilchenstrahlen mit unterschiedlichen Teilcheneigenschaften erzeugt. Bei einem Weg der Teilchen durch den Monochromator wird an dessen Ausgang ein Teilchenstrom hoher Monochromasie, beim alternativen Weg durch das zusätzliche Strahlführungssystem am Ausgang ein Teilchenstrom mit hoher Teilcheustromdichte zur Verfügung gestellt.

Zur Ablenkung werden ausschließlich elektrostatische Felder eingesetzt, die sich insbesondere durch einfache Herstellbarkeit der Vorrichtung auszeichnet.

Das Strahlerzeugungssystem gemäß der Erfindung ermöglicht, zwei strahlerzeugungssysteme herkömmlicher Bauart durch ein einziges Gerät zu ersetzen und innerhalb einer Apparatur wahlweise Teilchenströme mit den dargelegten unterschiedlichen Eigenschaften zur Verfügung zu stellen. Für die Analyse mikroskopischer Strukturen ergibt sich hieraus der Vorteil, Untersuchungen an ein und demselben Objekt und an demselben Ort nach unterschiedlichen Verfahren mit derselben Apparatur durchführen zu können.

Durch die Verminderung des apparativen Aufwandes werden erhebliche Kosten eingespart, da Apparaturen der genannten Art eine sehr hohe fertigungstechnische Präzision erfordern und dementsprechend kostspielig sind. Eine wesentliche Zeit- und damit Kostenersparnis ergibt sich auch dadurch, daß Untersuchungen nach unterschiedlichen Verfahren mit derselben Apparatur durchgeführt werden können.

Bei einer zweckmäßigen Ausbildung ist das zusätzliche Strahlführungssystem so angeordnet, daß es zwischen Ein- und Ausgang des Monochromators eine direkte d.h. unmittelbare Verbindung herstellt. Diese Ausführungsform ermöglicht eine sehr kompakte Bauweise des Strahlerzeugungssystems, da die Baumaße im wesentlichen nur durch die des Monochromators bestimmt werden.

Für eine kompakte Bauweise aber auch im Hinblick auf die einfache bauliche Realisierung ebenfalls von Nutzen ist, wenn das Umschaltelement ein Teilsystem des Monochromators selbst bildet. Der Begriff "Teilsystem" meint im Sinne der Erfindung, daß ein Teil eines Ablenkfeldes des Monochromators zur Umschaltung genutzt wird. Der durch das zusätzliche Strahlführungssystem erzeugte Strahlengang wird in diesem Fall durch einen Strahldurchtritt im Ablenkfeld erzeugt.

Beim Einsatz des Strahlerzeugungssystems in Untersuchungen mit unterschiedlichen Anforderungen an Teilchenstromdichte und Monochromasie ist es von Vorteil, wenn die Stromdichte regelbar ist. Im erfindungsgemäßen Strahlerzeugungssystem wird diese Regelung mittels einer Blende vorgeschlagen, die zwischen Umschaltelement und Strahlquelle angeordnet ist und mit Hilfe einer Justiervorrichtung senkrecht zur optischen Achse verschiebbar ausgerichtet ist. Zusätzlich oder alternativ hierzu kann die Regelung der Stromdichte auch mit Hilfe der Strahlquelle erfolgen. Für diesen Fall ist auch die Strahlquelle mit einer Justiervorrichtung ausgestattet, durch welche die Strahlquelle senkrecht zur optischen Achse verschoben werden kann.

Die Justiervorrichtung für Blende und/oder Strahlquelle läßt wenigstens zwei Einstellungen zu, wobei die eine Einstellung eine maximale und die andere eine niedrige Teilchenstromdichte am Ausgang des Strahlerzeugungssystems zur Verfügung stellt. Die Einstellung mit maximaler Teilchenstromdichte ist dadurch gegeben, daß Blende und Strahlquelle optimal justiert sind, was dann der Fall ist, wenn der Mittelpunkt von Blende und Strahlquelle auf der optischen Achse des zusätzlichen Strahlführungssystems liegen. In diesem Fall passiert eine maximal mögliche, nur durch den Blendendurchmesser begrenzte Anzahl von Teilchen die Blende. Eine Verschiebung der jeweiligen Mittelpunkte von Blende und/oder Strahlquelle aus dieser Position heraus in Richtung senkrecht zur optischen Achse führt jeweils zu einer Reduzierung der am Ausgang des Strahlerzeugnisses zur Verfügung gestellten Teilchenstromdichte. Eine geringe Teilchenstromdichte ist insbesondere bei Verwendung des Strahlerzeugungssystems zur Herstellung von Teilchen hohe Monochromasie von Bedeutung, da die geringe Dichte den Einfluß des Boersch-Effektes vermindert. Dieser

Begriff bezeichnet das Phänomen, daß bei Elektronenstrahlen, die in einem Punkt fokussiert werden, aufgrund der dann in diesem Bereich herrschenden hohen Stromdichte und der hieraus resultierenden gegenseitigen Beeinflussung der Elektronen die Energiebreite des Strahles eine drastische Aufweitung erfährt.

Bei einer vorteilhaften Weiterbildung wird die Justiervorrichtung zur Verschiebung von Blende und/oder Strahlquelle durch ein piezoelektrisches Element gebildet, bei dem die schrittweise Verschiebung durch Anlegen einer elektrischen Wechselspannung erzeugt wird. Mit diesem Element lassen sich Blende und/oder Strahlquelle sehr genau positionieren. Die gewünschte Position wird durch eine entsprechende Zeitdauer der Verschiebung eingestellt.

Die Justierung mittels Piezoelement weist gegenüber mechanischen Justiervorrichtungen den Vorteil einer hohen Genauigkeit der Positionierung auf. Als zusätzlicher Vorteil ist auch anzusehen, daß keinerlei externe mechanische Verstellglieder notwendig sind. Da das erfindungsgemäße Strahlerzeugungssystem im Hochvakuum eingesetzt wird, entfallen hierdurch technisch aufwendige Durchführungen durch die Wandung des Vakuumgefäßes.

Eine vorteilhafte Ausbildung des erfindungsgemäßen Strahlerzeugungssystems bei Verwendung elektrostatischer Felder innerhalb des Monochromators weist Elektroden auf, die in Schnitten senkrecht zur optischen Achse zumindest stückweise durch gerade Linien begrenzt sind und zu einer die optische Achse beinhaltenden Ebene spiegelsymmetrisch verlaufen. Durch die stückweise gerade oberflächengestaltung wird der Aufwand zur Herstellung dieser Elektroden vergleichsweise gering gehalten.

Weitere Einzelheiten, Merkmale und Vorteile der Erfindung lassen sich dem nachfolgenden Beschreibungsteil entnehmen, in dem anhand einer Zeichnung ein Ausführungsbeispiel des erfindungsgemäßen Strahlerzeugungssystems wiedergegeben wird.

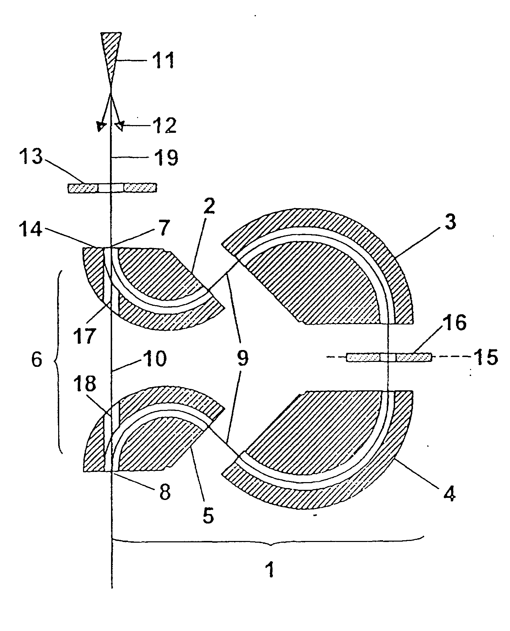

Die Zeichnung zeigt einen Schnitt durch das Strahlerzeugungssystem, welcher durch die optische Achse von Monochromator und zusätzlichen Strahlführungssystem gelegt ist.

Der Monochromator (1) mit seinen Ablenkelementen (2 - 5) ist in Form eines Ω aufgebaut. Das zusätzliche Strahlführungssystem (6) ist zwischen Eingang (7) und Ausgang (8) des Monochromators angeordnet. Die optische Achse des Monochromators wird durch das Bezugszeichen (9) wiedergegeben, das Bezugszeichen (10) bezeichnet die optische Achse des Strahlführungssystems.

Der von der Strahlquelle (11) kommende Teilchenstrom (12) wird durch die Blende (13) zur Regulierung der Teilchenstromdichte gelenkt. Im Anschluß daran passiert er das Umschaltelement (14), das in der dargestellten Ausführungsform ein Teilelement des Monochromators bildet. Abhängig vom Schaltzustand des Umschaltelementes wird der Teilchenstrom entweder durch den Monochromator umgelenkt oder dem zusätzlichen Strahlungssystem (6) zugeführt.

Bei einem Weg des Teilchenstroms durch den Monochromator folgt in der dispersiven Ebene (15) eine Aufspaltung des Strahls nach Energien der Teilchen. Mittels einer in diesen Ebene angeordneten Schlitzblende (16), deren Schlitz bei der vorliegenden Ausführungsform des Monochromators senkrecht zur Zeichenebene steht, erfolgt die Selektion der Teilchen nach Energien. Dabei wird durch die Breite der Blende die Breite des Energiespektrums und durch den Abstand des Blendenmittelpunktes von der optischen Achse die mittlere Energie des Teilchenstrahls festgelegt. Bei einer Einstellung der Schlitzblende auf geringe Breite wird am Ausgang (8) des Monochromators ein Teilchenstrahl hoher Monochromasie zur Verfügung gestellt.

Bei einem Weg des Teilchenstroms durch das zusätzliche Strahlführungssystems (6) passiert der Teilchenstrom im vorliegenden Ausführungsbeispiel einen Strahldurchtritt (17) im Umlenkelement und wird durch einen gleichgestalteten Strahldurchtritt (18) am Ausgang des Monochromators in diesen wieder eingefädelt. Bei einer optimalen Justierung von Strahlquelle (11) und Blende (13), d. h. z. B. wenn ihre Mittelpunkte auf der optischen Achse (19) des Strahlerzeugungssystems liegen, wird am Ausgang des zusätzlichen Strahlführungssystems, der im vorliegenden Ausführungsbeispiel mit dem Ausgang des Monochromators zusammenfällt, ein Teilchenstrahl hoher Stromdichte zur Verfügung gestellt.

## Patentansprüche

1. Strahlerzeugungssystem für Elektronen oder Ionenstrahlen mit einer Strahlenquelle (11) und mit einem Monochromator (1) mit ausschließlich elektrostatischen Ablenkfeldern, welche in der dispersiven Ebene (15) ein astigmatisches Zwischenbild der Strahlenquelle (11) erzeugen, und mit einer Schlitzblende (16) in der dispersiven Ebene mit einer Orientierung des Schlitzes in Richtung der Längsausdehnung des astigmatischen Zwischenbildes, **dadurch gekennzeichnet, daß** der Monochromator mit einem zusätzlichen Strahlführungssystem (6) ausgestattet ist und an seinem Eingang (7) ein Umschaltelement (14) aufweist, das die von der Strahlquelle (11) kommenden Teilchen entweder in den Monochromator (1) oder dem zusätzlichen Strahlführungssystem (6) zuführt.

2. Strahlerzeugungssystem nach Anspruch 1, **dadurch gekennzeichnet, daß** das zusätzliche Strahlführungssystem (6) eine direkte Verbindung zwischen Ein- und Ausgang (7; 8) des Monochromators (1) herstellt.

3. Strahlerzeugungssystem nach Anspruch 1 oder 2, **dadurch gekennzeichnet, daß** das Umschaltelement (14) einen Teil eines Ablenkfeldes des Monochromators (1) selbst darstellt und einen Strahldurchtritt (17) für den durch das zusätzliche Strahlführungssystem (6) erzeugten Strahlengang aufweist.

4. Strahlerzeugungssystem nach einem der Ansprüche 1 bis 3, **dadurch gekennzeichnet, daß** zwischen Umschaltelement (14) und Strahlquelle (11) eine Blende (13) und eine Justiervorrichtung vorgesehen ist, durch welche die Blende senkrecht zur optischen Achse (19) verschiebbar ist.

5. Strahlerzeugungssystem nach einem der Ansprüche 1 bis 4, **dadurch gekennzeichnet, daß** eine Justiervorrichtung vorgesehen ist, durch welche die Strahlquelle (11) senkrecht zur optischen Achse (19) verschiebbar ist.

6. Strahlerzeugungssystem nach Anspruch 4 oder 5, **dadurch gekennzeichnet, daß** die Justiervorrichtung aus einem piezoelektrischen Element besteht.

7. Strahlerzeugungssystem nach einem der vorangehenden Ansprüche, **dadurch gekennzeichnet, daß** die die Felder erzeugenden Elektroden (2-5) in Schnitten senkrecht zur optischen Achse (9) zumindest stückweise durch gerade Linien begtenzt sind und zu einer die optische Achse beinhaltenden Ebene spiegelsymmetrisch verlaufen.

8. Verwendung des Strahlenerzeugungssystems nach einem der vorangehenden Ansprüche, **dadurch gekennzeichnet, daß** es in den Strahlengang von elektronenoptischen Systemen, wie Elektronenmikroskopen eingebaut wird.

## Claims

1. A beam generating system for electrons or ion beams, which comprises a beam source (11) and comprising a monochromator (1) with exclusively electrostatic deflection fields, which, in the dispersive plane (15), generates an astigmatic intermediate image of the beam source (11), and comprising a slit aperture in the dispersive plane (16) with an orientation of the slit in the direction of longitudinal extension of the astigmatic intermediate image, **characterised in that** the monochromator is equipped with an additional beam guidance system (6) and has at its input (7) a switch element (14), which guides the particles coming from the beam source (11) either into the monochromator or to the additional beam guidance system (6).

2. Beam generation system according to claim 1, **characterised in that** the additional beam guidance system (6) produces a direct connection between the input and output (4; 8) of the monochromator (1).

3. Beam generation system according to claim 1 or 2, **characterised in that** the switch element (14) represents part of a deflection field of the monochromator (1) itself, and has a beam passage (17) for the beam path generated by the additional beam guidance system (6).

4. Beam generation according to one of claims 1 to 3, **characterized in that** an aperture (13) is disposed between the switch element (14) and beam source (11), and an adjustment device is provided, by means of which the aperture is displaceable perpendicular to the optical axis (1).

5. Beam generation according to one of claims 1 to 4, **characterised in that** an adjustment system is provided, by means of which the beams source (11) can be displaced perpendicular to the optical axis (19).

6. Beam generation system according to claim 4 or 5, **characterised in that** the adjustment device consists of a piezoelectric element.

7. Beam generation system according to one of the preceding claims, **characterised in that** the electrodes (2-5) generating the fields are delimited at least piece-wise in sections perpendicular to the optical axis (9) by means of straight lines, and extend mirror-symmetrically to a plane including the optical axis.

8. Use of the beam generation system according to one of the preceding claims, **characterised in that** it is installed in the beam path of electron-optical systems such as electron microscopes.

## Revendications

1. Canon électronique pour électrons ou faisceaux ioniques avec une source de faisceaux (11) et un monochromateur (1) exclusivement équipé de champs de déflexion électrostatiques qui génèrent une image intermédiaire astigmatique de la source de faisceaux dans le plan dispersif (15), et d'un écran fendu (16) dans le plan dispersif, la fente de l'écran étant orientée dans le sens de l'extension longitudinale de l'image intermédiaire, **caractérisé en ce que**
le monochromateur est équipé d'un système complémentaire de guidage du faisceau (6) et présente à son entrée (7) un dispositif de commutation (14) qui dirige les particules issues de la source de faisceaux (11) vers le monochromateur ou vers le système de guidage complémentaire du faisceau (6).

2. Canon électronique suivant la revendication 1, **caractérisé en ce que** le système complémentaire de guidage du faisceau (6) forme en lui-même une liaison directe entre l'entrée et la sortie (7, 8) du monochromateur (1).

3. Canon électronique suivant la revendication 1 ou 2, **caractérisé en ce que** le dispositif de commutation (14) est lui-même partie intégrante du champ de déflexion du monochromateur (1) et présente un orifice (17) par lequel passe la trajectoire du faisceau issu du système complémentaire de guidage du faisceau (6).

4. Canon électronique suivant l'une des revendications 1 à 3, **caractérisé en ce que** celui-ci est équipé d'un écran (13) et d'un système d'ajustage situés entre le dispositif de commutation (14) et la source du faisceau (11), le système d'ajustage permettant de déplacer l'écran perpendiculairement à l'axe optique (19).

5. Canon électronique suivant l'une des revendications 1 à 4, **caractérisé en ce que** celui-ci est équipé d'un système d'ajustage permettant de décaler la source du faisceau (11) perpendiculairement à l'axe optique (19).

6. Canon électronique suivant l'une des revendications 4 ou 5, **caractérisé en ce que** le système d'ajustage se compose d'un élément piézoélectrique.

7. Canon électronique suivant l'une des revendications précédentes, **caractérisé en ce que** les électrodes (2-5) générant les champs sont au moins en partie limitées perpendiculairement à l'axe optique (19) par des lignes droites et sont placées symétriquement par rapport au plan contenant l'axe optique (19).

8. Utilisation du canon électronique suivant l'une des revendications précédentes, **caractérisée en ce que** celui-ci est monté dans la trajectoire du faisceau de systèmes électro-optiques tels que des microscopes électroniques.
